# EUROPEAN PATENT APPLICATION

(11) **EP 4 465 223 A1**
(43) Date of publication of application: **20.11.2024**
(21) Application number: 22920547.1
(22) Date of filing: 14.12.2022
(51) Int. Cl.: G06Q 10/20, G06Q 50/04, G06Q 50/06, G06Q 50/08

(54) **EQUIPMENT MAINTENANCE METHOD, DEVICE, AND SYSTEM**

(30) Priority: 11.01.2022 CN 202210025817
(71) Applicant: DAIKIN INDUSTRIES, LTD., Osaka-shi, Osaka 530-0001 (JP)
(72) Inventor: WANG, Qi, Osaka-shi, Osaka 530-0001 (JP)
(74) Representative: Conti, Marco
(86) International application number: PCT/JP2022/045967
(87) International publication number: WO 2023/136029

(57) **Abstract**

The present invention relates to a device maintenance method, apparatus, and system. A simulation scene is created based on an engineering model of an installation location of a device and displayed, and a maintenance operator is assisted to identify a target device in the simulation scene. In addition, in a site where the target device is located, a maintenance operator is assisted to display related information of the target device and the simple interaction with the simulation scene. Accordingly, not only the maintenance efficiency can be effectively improved, but also it helps the maintenance operator inspect and repair a hidden device.

## Description

### Technical Field

The present invention relates to the field of device maintenance, and more specifically to a device maintenance method, apparatus, and system.

### Background Art

With the development of science and technology, various devices are applied to individual lives and fields of production.

Currently, after a device has failed, an after-sales service person needs to visit a house to check and confirm information on the failed device, find a failed part, and then place an order to the part supplier. In a stage in which an after-sales service person visits a house to check and confirm a failed device and find a failed part, the following general operation process is performed.

The after-sales service person manually removes and inspects the device according to their experience on site, and provides the model number and part information of the device to a manager. The manager searches, based on the provided information, a device management website for the ID of the part in an exploded diagram of the device. The manager further registers in a part inventory website to search for the inventory information and the price of the part according to the ID of the part, and feeds the inventory information and the price back to the after-sales service person.

In recent years, some technologies for supporting device management and maintenance in accordance with virtual display have appeared. For example, a mark of virtual display is set on a device. The mark is scanned by a mobile phone terminal to browse operation information of the device.

It should be noted that the foregoing introduction to the technical background is merely described for convenience of clearly and completely describing the technical contents of the present invention and for ease of understanding by those skilled in the art. Since these technical contents have been described in the background section of the present invention, the technical contents described above cannot be regarded as being known to those skilled in the art.

### Summary of Invention

However, the inventors have found that the method of manual inspection, repair, and maintenance is to remove and inspect a device mainly according to the experience, which results in low maintenance efficiency, long time taken for maintenance, and more difficult and slow repair of a hidden failed device, pipe wiring, and so on, and even if virtual display technology is introduced, the process is usually complicated; for example, the technique of the related art requires setting of a mark of virtual display on each device, which results in an increase in process complexity and cost.

To address at least one of the issues described above, examples of the present invention provide a device maintenance method, apparatus, and system, in which a simulation scene is created based on an engineering model of an installation location of a device and displayed, and a maintenance operator is assisted to identify a target device in the simulation scene. In addition, in a site where the target device is located, related information of the target device is displayed, and a maintenance operator is assisted to perform maintenance on the target device. In this way, a simulation scene of maintenance is formed based on the engineering model, the maintenance operator more easily identifies the target device, which requires maintenance, and the related information of the target device and the simple interaction with the simulation scene are displayed at the device site on the basis of the simulation scene. This helps the maintenance operator more quickly identify a target part that requires maintenance in the target device. Accordingly, not only the maintenance efficiency can be effectively improved, but also the simulation scene helps the maintenance operator inspect and repair a hidden device.

A first aspect of examples of the present invention provides a device maintenance method including acquiring an engineering model of an installation location of a device; creating and displaying a simulation scene based on the engineering model, and assisting a maintenance operator to identify a target device in the simulation scene; and in a site where the target device is located, displaying related information of the target device, based on the simulation scene, and assisting the maintenance operator to perform maintenance on the target device.

A second aspect of the examples of the present invention provides a device maintenance apparatus including acquisition means for acquiring an engineering model of an installation location of a device, first display means for creating and displaying a simulation scene based on the engineering model, and assisting a maintenance operator to identify a target device in the simulation scene, and second display means for, in a site where the target device is located, displaying related information of the target device, based on the simulation scene, and assisting the maintenance operator to perform maintenance on the target device.

A third aspect of the examples of the present invention provides a device maintenance system including the apparatus according to the second aspect of the examples of the present invention, and a detection device that detects a line of sight and/or an action of a maintenance operator.

In one of the beneficial effects of the examples of the present invention, a simulation scene is created based on an engineering model of an installation location of a device and displayed, and a maintenance operator is assisted to identify a target device in the simulation scene. In addition, in a site where the target device is located, related information of the target device is displayed, and a maintenance operator is assisted to perform maintenance on the target device. In this way, a simulation scene of maintenance is formed based on the engineering model, the maintenance operator more easily identifies the target device, which requires maintenance, and the related information of the target device and the simple interaction with the simulation scene are displayed at the device site on the basis of the simulation scene. This helps the maintenance operator more quickly identify a target part that requires maintenance in the target device. Accordingly, not only the maintenance efficiency can be effectively improved, but also the simulation scene helps the maintenance operator inspect and repair a hidden device.

With reference to the following description and the drawings, specific embodiments of the present invention are disclosed in detail, and aspects in which the principles of the present invention may be employed are illustrated. It should be understood that embodiments of the present invention are not limited in scope. Many modifications, corrections, and equivalents are included in the embodiments of the present invention within the spirit and scope of the appended claims.

Features described and/or illustrated with respect to one embodiment may be used in one or more other embodiments in the same way or in a similar way, may be combined with features in other embodiments, or may replace features in other embodiments.

It should be emphasized that the term "comprise/include", as used herein, indicates the presence of feature information, an assembly, a step, or a member but does not preclude the presence/addition of one or more other pieces of feature information, assemblies, steps, or members.

### Brief Description of Drawings

Many aspects of the present invention can be better understood with reference to the following drawings. The members in the drawings are not necessarily to scale, emphasis instead being placed upon illustrating the principles of the present invention. To illustrate and describe some portions of the present invention, the corresponding portions may be enlarged or reduced in size in the drawings. Elements and feature information described in one drawing or one embodiment of the present invention may be combined with elements and feature information illustrated in one or more other drawings or embodiments. In the drawings, moreover, like reference numerals designate corresponding members throughout several views, and may be used to designate corresponding members used in one or more embodiments. The drawings include the following figures.
[Fig. 1] Fig. 1 is a flowchart of a device maintenance method according to Example 1 of the present invention.
[Fig. 2] Fig. 2 is a flowchart of a method for assisting a maintenance operator to identify a target device in the simulation scene according to Example 1 of the present invention.
[Fig. 3] Fig. 3 is a flowchart of a method for implementing step 103 according to Example 1 of the present invention.
[Fig. 4] Fig. 4 is a flowchart of another method for implementing step 103 according to Example 1 of the present invention.
[Fig. 5] Fig. 5 is a flowchart of a method for implementing step 402 according to Example 1 of the present invention.
[Fig. 6] Fig. 6 is a flowchart of a method for implementing step 403 according to Example 1 of the present invention.
[Fig. 7] Fig. 7 is a flowchart of another method for implementing step 403 according to Example 1 of the present invention.
[Fig. 8] Fig. 8 is a flowchart of still another method for implementing step 403 according to Example 1 of the present invention.
[Fig. 9] Fig. 9 is a flowchart of still another method for implementing step 403 according to Example 1 of the present invention.
[Fig. 10] Fig. 10 is a flowchart of a method for implementing step 902 according to Example 1 of the present invention.
[Fig. 11] Fig. 11 is another flowchart of a device maintenance method according to Example 1 of the present invention.
[Fig. 12] Fig. 12 is a flowchart of a specific implementation of a device maintenance method according to Example 1 of the present invention.
[Fig. 13] Fig. 13 is a schematic diagram of a device maintenance apparatus according to Example 2 of the present invention.
[Fig. 14] Fig. 14 is a structural diagram of a device maintenance system according to Example 3 of the present invention.

### Description of Embodiments

Preferred embodiments of the present invention will be described hereinafter with reference to the drawings.

### <Example 1>

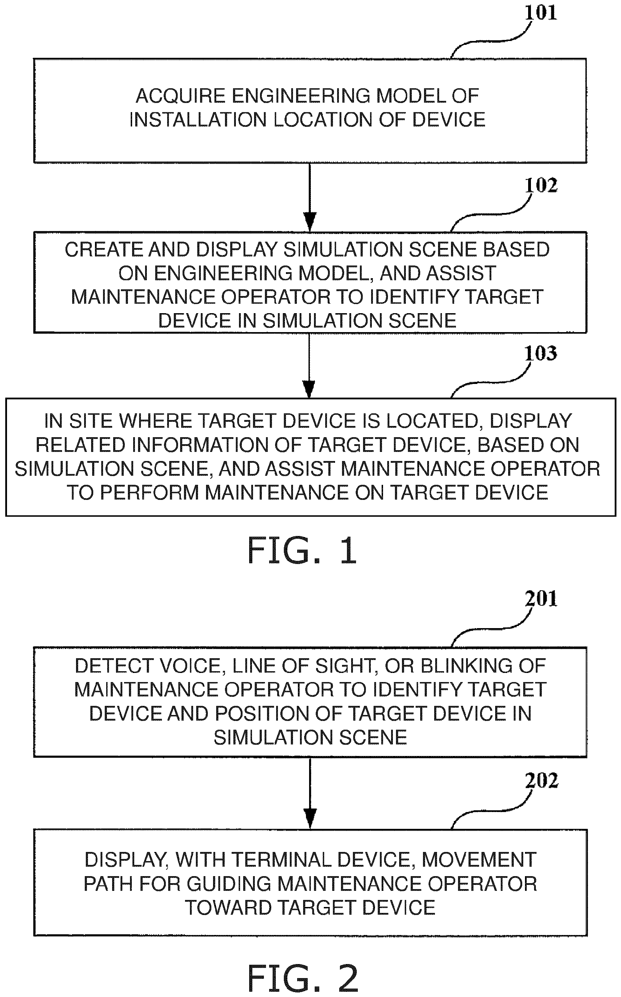

Example 1 of the present invention provides a device maintenance method. Fig. 1 is a flowchart of a device maintenance method according to Example 1 of the present invention. As illustrated in Fig. 1, the method includes:
step 101 of acquiring an engineering model of an installation location of a device;
step 102 of creating and displaying a simulation scene based on the engineering model, and assisting a maintenance operator to identify a target device in the simulation scene; and
step 103 of, in a site where the target device is located, displaying related information of the target device, based on the simulation scene, and assisting the maintenance operator to perform maintenance on the target device.

In this way, a simulation scene of maintenance is formed based on the engineering model, the maintenance operator more easily identifies the target device, which requires maintenance, and the related information of the target device and the simple interaction with the simulation scene are displayed at the device site on the basis of the simulation scene. This helps the maintenance operator more quickly identify a target part that requires maintenance in the target device. Accordingly, not only the maintenance efficiency can be effectively improved, but also the simulation scene helps the maintenance operator inspect and repair a hidden device.

In an example of the present application, a device model of a target device may be directly acquired without acquisition of an engineering model of an installation location of a device, and the device model may be displayed. That is, step 103 may directly be executed without execution of step 101 and step 102. In addition, step 103 involves acquiring a device model of a target device, displaying the parts of the device model in a developed form, identifying a target part that may fail, and acquiring information on the target part.

For example, the maintenance operator selects a model number of a device and acquires a device model corresponding to the model number of the device from a background. The device model is directly decomposed and developed to select a failed part and identify information on the part.

A specific implementation method can be performed with reference to the detailed description of step 103 below.

In an example of the present invention, a device that performs the method may be, for example, a terminal device, and the terminal device is, for example, an augmented reality (AR) device, a virtual reality (VR) device, or a mixed reality (MR) device.

In an example of the present invention, the AR device may be, for example, any type of AR device such as AR glasses, a smartphone, a tablet, or a customized AR hand-held device.

In an example of the present invention, the target device that is a maintenance target may be, for example, any type of device such as an air conditioner, a fresh air device, or a floor heating device. The maintenance target device may further include, for example, various pipes such as a refrigerant pipe, an electric wire pipe, and a condensed water pipe for an air conditioner.

In an example of the present invention, the target device that is a maintenance target may include, for example, an indoor unit installed on a suspended ceiling, and a device installed in a hidden manner, such as various pipes.

In an example of the present invention, the timing of performing the method may be, for example, the timing at which a fault occurs in a device or the timing of performing periodic maintenance or the like.

In an example of the present invention, an installation location of a device refers to a site where an installed device is located. For example, the installation location may be in a building or outdoors.

In an example of the present invention, the engineering model may be, for example, any type of three-dimensional engineering model such as building information model (Building Information Modeling, BIM).

In step 101, an engineering model of an installation location of a device is acquired.

For example, a BIM model of the installation location of the device is acquired from a cloud server or an existing BIM platform.

After the engineering model is acquired, in step 102, a simulation scene is created based on the engineering model and displayed, and the maintenance operator is assisted to identify a target device in the simulation scene.

For example, the engineering model is positioned in the site where the target device is located, to superimpose the engineering model on the site. In addition, a terminal device displays the engineering model, that is, the terminal device displays the simulation scene of maintenance.

A specific positioning method may be performed using various positioning techniques.

For example, positioning may be performed by two location points in the site, or positioning may be performed by three location points in the site. Alternatively, positioning may be performed by scanning a two-dimensional code in the site, positioning may be performed by a magnetometer, or positioning may be performed by using ultra-wideband (UWB) technology. Alternatively, positioning may be performed by a combination of a plurality of methods of the methods described above.

For example, the terminal device is an AR device, a VR device, or an MR device.

After the simulation scene of maintenance is created and displayed, the maintenance operator can be assisted to identify a target device in the simulation scene.

Fig. 2 is a flowchart of a method for assisting the maintenance operator to identify a target device in the simulation scene according to Example 1 of the present invention. As illustrated in Fig. 2, the method includes the following steps.

In step 201, a voice, a line of sight, or blinking of the maintenance operator is detected to identify a target device and the position of the target device in the simulation scene.

For example, a voice command including the name of the target device issued by the maintenance operator is detected, and the target device on which the maintenance operator is to perform maintenance and the position of the target device are identified in the simulation scene.

For example, furthermore, the eyeball of the maintenance operator is tracked, that is, the line of sight of the maintenance operator is tracked and detected, and the target device on which the maintenance operator is to perform maintenance and the position of the target device are identified in the simulation scene.

For example, furthermore, a blinking action of the maintenance operator is detected, and the target device on which the maintenance operator is to perform maintenance and the position of the target device are identified in the simulation scene.

In an example of the present invention, a method for specifically detecting the voice, the line of sight, or the blinking of the maintenance operator can be performed with reference to related technologies, and the detailed description thereof will be omitted herein.

Further, after the target device and the position thereof are identified, the displayed simulation scene can be marked.

In this way, the detection of the voice, the line of sight, or the blinking of the maintenance operator enables quick finding of the target device.

In an example of the present invention, as illustrated in Fig. 2, the method may further include step 202 of displaying, with a terminal device, a movement path for guiding the maintenance operator toward the target device.

For example, a path from the current position to the target device in the displayed simulation scene is displayed.

As described above, the maintenance operator in the site can be guided to conveniently and quickly reach the location where the target device is located, and further start inspection and maintenance of the target device.

After the maintenance operator reaches the location where the target device is located, in step 103, related information of the target device is displayed, based on the simulation scene, at the site where the target device is located, and the maintenance operator is assisted to perform maintenance on the target device.

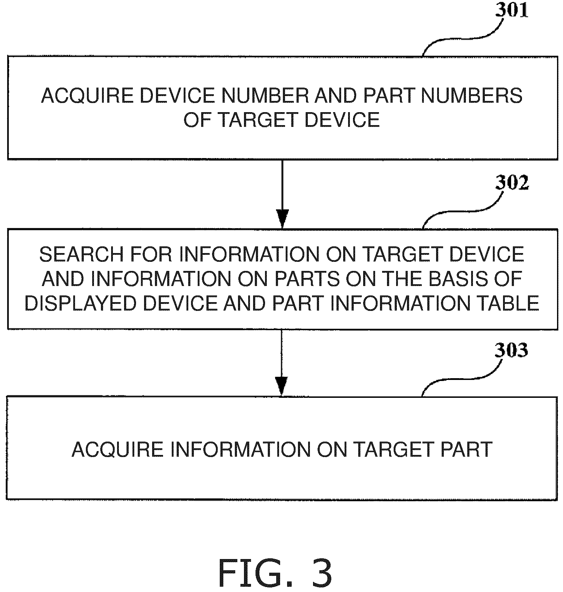

Fig. 3 is a flowchart of a method for implementing step 103 according to Example 1 of the present invention. As illustrated in Fig. 3, the method includes:
step 301 of acquiring a device number and part numbers of the target device;
step 302 of searching for information on the target device and information on parts on the basis of a displayed device and part information table; and
step 303 of acquiring information on a target part.

For example, the device number and the part numbers of the target device are automatically acquired, and the corresponding device and part information table is acquired from a database and displayed. In this way, the maintenance operator can use a table lookup method to quickly find the number corresponding to a part that requires maintenance, and can quickly identify a repair means.

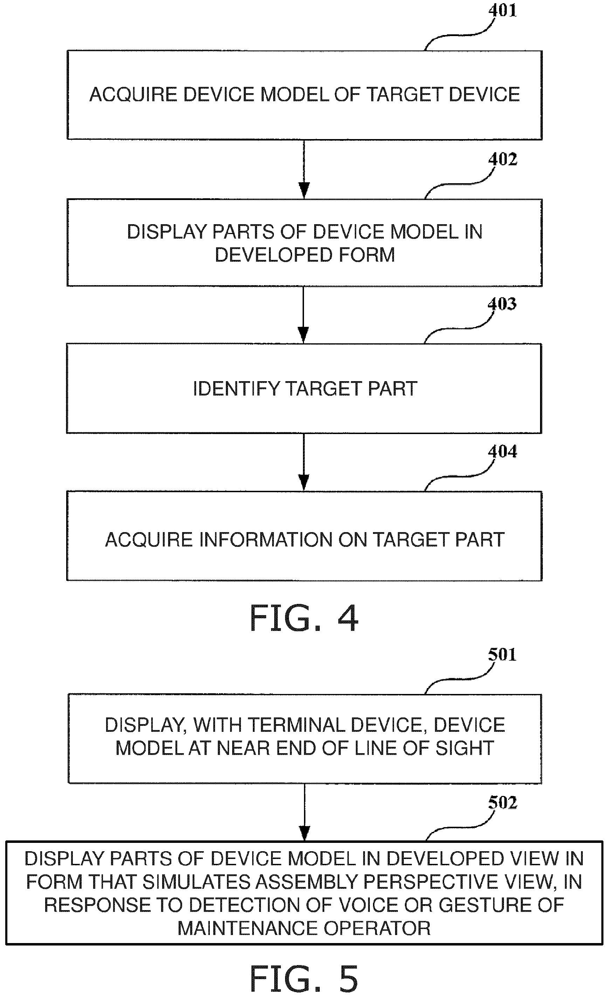

Fig. 4 is a flowchart of another method for implementing step 103 according to Example 1 of the present invention. As illustrated in Fig. 4, the method includes:
step 401 of acquiring a device model of the target device;
step 402 of displaying the parts of the device model in a developed form;
step 403 of identifying a target part; and
step 404 of acquiring information on the target part.

For example, a device model of a target device is acquired from a background or a database. The device model is a 3D model.

In this way, the maintenance operator can intuitively and quickly identify a target part that requires maintenance, and acquire related information, resulting in a further improvement in maintenance efficiency.

In step 402, the parts of the device model are displayed in a developed form. For example, the parts are displayed in the form of an assembly perspective view.

Fig. 5 is a flowchart of a method for implementing step 402 according to Example 1 of the present invention. As illustrated in Fig. 5, the method includes:
step 501 of displaying, with a terminal device, the device model at the near end of the line of sight; and
step 502 of displaying the parts of the device model in a developed view in a form that simulates an assembly perspective view, in response to detection of a voice or gesture of the maintenance operator.

In this way, the maintenance operator can conveniently and intuitively view the parts.

In step 402, furthermore, the parts of the device model can be displayed in a developed view in response to detection of a removal action of the target device by the maintenance operator. In this way, the exploded display of the parts can be synchronized with an actual removal action, which provides more convenience for the maintenance operator to work and improves maintenance efficiency.

In step 403, a target part is identified. Various methods for identifying a target part will be described in detail hereinafter.

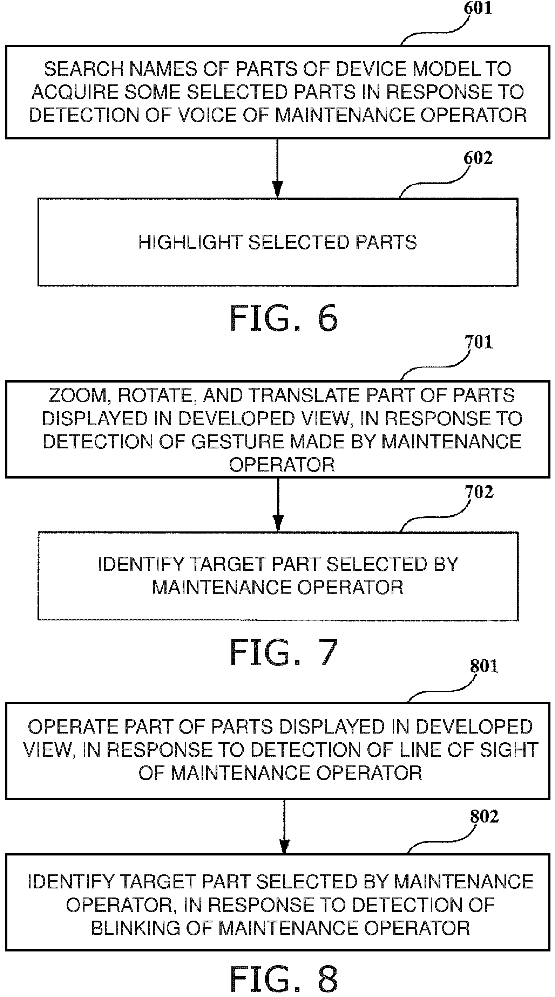

Fig. 6 is a flowchart of a method for implementing step 403 according to Example 1 of the present invention. As illustrated in Fig. 6, the method includes:
step 601 of searching the names of the parts of the device model to acquire some selected parts in response to detection of the voice of the maintenance operator; and
step 602 of highlighting the selected parts.

For example, after viewing the parts that are displayed in a developed view, the maintenance operator identifies a part in which a fault may occur, and issues a voice including a portion of or the entire name of the part. In response to detection of the voice, the name is recognized as a keyword, and a fuzzy search is performed based on the keyword to highlight all parts of the device model whose names include the keyword. After the fuzzy search and selection, a voice can further be input to perform a further search and selection to identify a target part, or a gesture operation can be performed to visually identify a target part.

Alternatively, the maintenance operator may issue a voice including the number or the name of a part, and perform accurate matching in response to detection of the voice. In addition, the maintenance operator can highlight the part in the device model.

The voice issued by the maintenance operator does not include the name or the number of the device but may include a keyword for control. For example, in response to a voice including similar content such as decomposing and developing or automatic model development, processing such as decomposing and developing of the device model is executed.

In this way, the maintenance operator can conveniently and intuitively identify and view a target part, resulting in a further improvement in maintenance efficiency.

In an example of the present invention, some parts may be highlighted by using various methods. For example, a part required to be highlighted can be displayed in a highlighted manner, or a part required to be highlighted can be rendered and displayed in a different color.

Alternatively, a part required to be highlighted may be moved to the near end of the line of sight.

Fig. 7 is a flowchart of another method for implementing step 403 according to Example 1 of the present invention. As illustrated in Fig. 7, the method includes:
step 701 of zooming, rotating, and translating a part of the parts displayed in a developed view, in response to detection of a gesture made by the maintenance operator; and
step 702 of identifying a target part selected by the maintenance operator.

In this way, the maintenance operator can perform a simple gesture to perform various forms of operations on a target part in the virtual scene, which helps the maintenance operator quickly identify the target part.

Fig. 8 is a flowchart of still another method for implementing step 403 according to Example 1 of the present invention. As illustrated in Fig. 8, the method includes:
step 801 of operating a part of the parts displayed in a developed view, in response to detection of the line of sight of the maintenance operator; and
step 802 of identifying a target part selected by the maintenance operator, in response to detection of blinking of the maintenance operator.

In this way, the maintenance operator can operate or identify a target part in the virtual scene by a simple action such as gazing or blinking.

In step 801, the maintenance operator may perform an operation by gazing and rotating the eyeballs. For example, the maintenance operator may move the eyeballs up, down, and to the sides to rotate the model, and further perform actions such as blinking, gazing, and then rotating their head to operate the model.

In step 802, for example, the maintenance operator quickly blinks twice to select a target part. The target part is a part at which the line of sight is located after the maintenance operator blinks twice.

In step 403, based on further various kinds of information, a candidate target part in which a fault may occur can be distributed to the maintenance operator via push notification.

In an example of the present invention, the candidate target part to be distributed to the maintenance operator via push notification may be a single part, or may include a plurality of parts such as a list of a plurality of parts, for example.

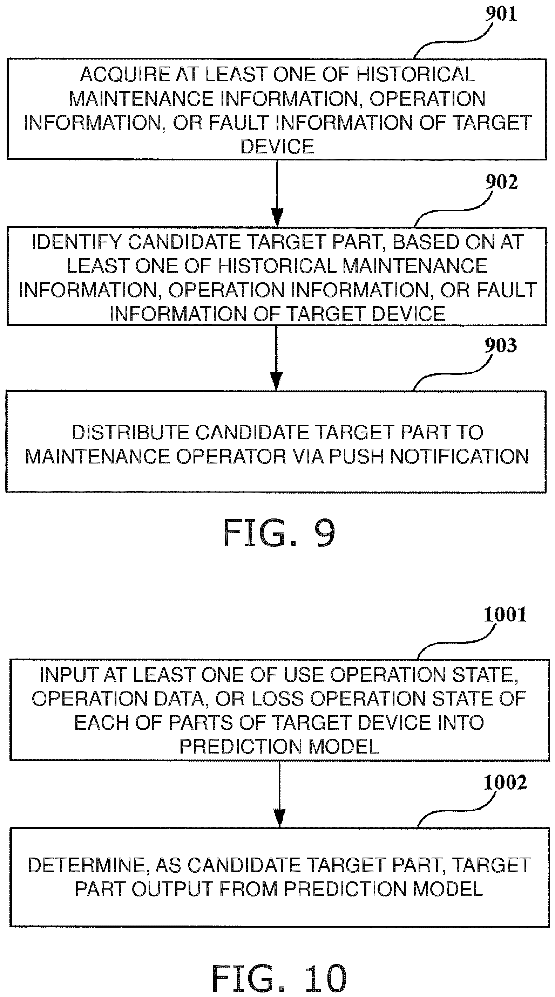

Fig. 9 is a flowchart of still another method for implementing step 403 according to Example 1 of the present invention. As illustrated in Fig. 9, the method includes:
step 901 of acquiring at least one of historical maintenance information, operation information, or fault information of the target device;
step 902 of identifying a candidate target part, based on at least one of the historical maintenance information, the operation information, or the fault information of the target device; and
step 903 of distributing the candidate target part to the maintenance operator via push notification.

In this way, automatically distributing the candidate target part via push notification, based on at least one of the historical maintenance information, the operation information, or the fault information of the target device, can reduce the inspection time of the maintenance operator and further improve the maintenance efficiency and accuracy rate.

For example, the fault information includes a fault code. In step 902, a part in which a fault corresponding to the fault code may occur is determined as a candidate target part.

In this way, the fault code allows easy and quick identification of a candidate target part, and can further improve the maintenance efficiency and accuracy rate.

In addition, a candidate target part can be identified further based on a prediction model.

Fig. 10 is a flowchart of a method for implementing step 902 according to Example 1 of the present invention. As illustrated in Fig. 10, the method includes:
step 1001 of inputting at least one of the use operation state, operation data, or the loss operation state of each of the parts of the target device into a prediction model; and
step 1002 of determining, as a candidate target part, a target part output from the prediction model.

In an example of the present invention, the prediction model is, for example, an AI model obtained by training.

For example, the use times, the use operation states, and operation parameters of the parts are input into the neural network, and the ranking of the parts in terms of loss is output. A candidate target part is output according to the ranking, and the model is stored after the model converges.

In this way, identifying a candidate target part based on a prediction model created in advance can be applied to a situation in which a fault has occurred in each part, resulting in wider applicability and a further improvement in maintenance efficiency.

In an example of the present invention, a candidate target part may be identified further based on historical maintenance information of the device.

For example, in step 902, a candidate target part is identified based on the number of repairs of each part in the historical maintenance information of the target device.

For example, a part having the largest number of repairs or parts having several largest numbers of repairs are selected as a candidate target part or parts.

In this way, a candidate target part can be easily identified based on historical maintenance information.

In step 903, the candidate target part is distributed to the maintenance operator via push notification. For example, the candidate target part is highlighted.

For example, a part required to be highlighted is displayed in a highlighted manner, or a part required to be highlighted is rendered and displayed in a different color. Alternatively, a part required to be highlighted may be moved to the near end of the line of sight.

Further, for example, a list of candidate target parts is displayed.

In an example of the present invention, the various methods for identifying a target part described above may be used individually or in combination.

After a target part is identified in step 403, information on the target part is acquired in step 404.

For example, in response to selection of a target part by the maintenance operator, detailed information of the target part is searched for and displayed.

For example, the ID on the model is acquired by double-clicking, and the ID number of the corresponding part is used to search for information on the corresponding target part.

In an example of the present invention, the detailed information of the target part can include at least one of shipment information, supplier information, price information, inventory information, repair guidance information, or attachment-and-removal guidance information of the target part.

In an example of the present invention, the repair guidance information and the attachment-and-removal guidance information can be dynamically displayed in the form of a moving image or video. In this way, the maintenance operator can intuitively refer to such information, resulting in a further improvement in maintenance efficiency.

In this way, it is possible to provide convenience for the maintenance operator to work on a target part, resulting in a further improvement in maintenance efficiency.

For example, the maintenance operator can perform a gesture to open an inventory information display page, and perform another gesture to open a shipment information display page or the like.

In an example of the present invention, the detailed information may further include order information of a target part. For example, the method further includes generating an order based on the order information in response to an operation of the maintenance operator.

For example, the maintenance operator performs an order operation on a displayed order page.

In this way, the maintenance operator can directly perform an order operation, resulting in a further improvement in maintenance efficiency.

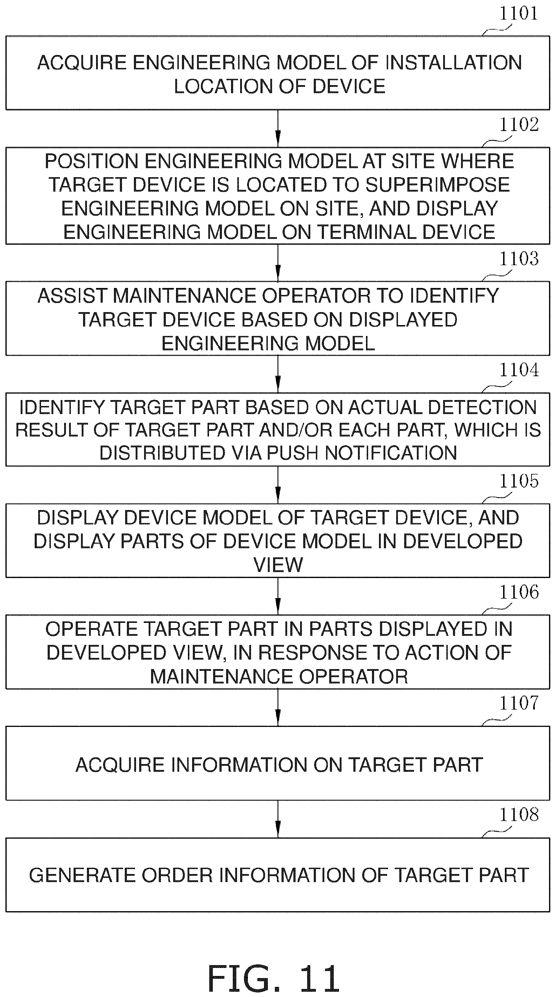

Fig. 11 is another flowchart of a device maintenance method according to Example 1 of the present invention. As illustrated in Fig. 11, the method includes:
step 1101 of acquiring an engineering model of an installation location of a device;
step 1102 of positioning the engineering model at a site where a target device is located to superimpose the engineering model on the site, and displaying the engineering model on a terminal device;
step 1103 of assisting a maintenance operator to identify a target device based on the displayed engineering model;
step 1104 of identifying a target part based on an actual detection result of the target part and/or each part, which is distributed via push notification;
step 1105 of displaying a device model of the target device, and displaying the parts of the device model in a developed view;
step 1106 of operating the target part in the parts displayed in a developed view, in response to an action of the maintenance operator;
step 1107 of acquiring information on the target part; and
step 1108 of generating order information of the target part.

The steps described above can be specifically implemented with reference to the foregoing description, and the detailed description thereof will be omitted herein.

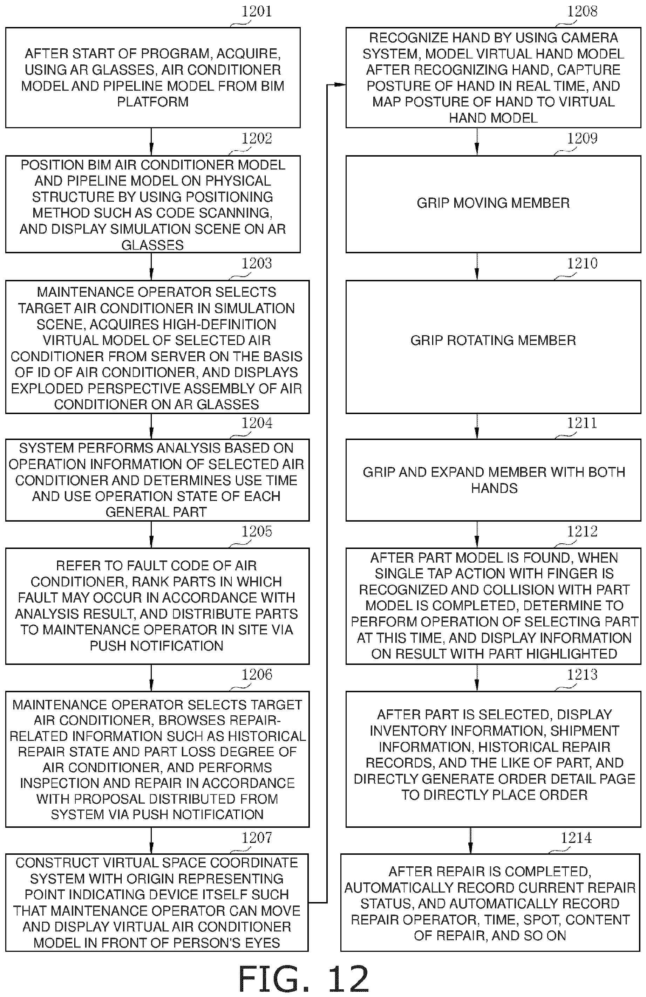

Fig. 12 is a flowchart of a specific implementation of a device maintenance method according to Example 1 of the present invention. The target device is an air conditioner, by way of example. As illustrated in Fig. 12, the method includes:
step 1201 of, after start of a program, acquiring, using AR glasses, an air conditioner model and a pipeline model from a BIM platform;
step 1202 of positioning the BIM air conditioner model and the pipeline model on a physical structure by using a positioning method such as code scanning, and displaying a simulation scene on the AR glasses;
step 1203 in which a maintenance operator selects a target air conditioner in the simulation scene, acquires a high-definition virtual model of the selected air conditioner from a server on the basis of the ID of the air conditioner, and displays an exploded perspective assembly of the air conditioner on the AR glasses;
step 1204 in which the system performs analysis based on operation information of the selected air conditioner and determines the use time and use operation state of each general part, such as the operating time, the operating temperature, and the operating time, for example;
step 1205 of referring to a fault code of the air conditioner, ranking parts in which a fault may occur in accordance with the analysis result, and distributing the parts to the maintenance operator in the site via push notification;
step 1206 in which the maintenance operator selects a target air conditioner, browses repairrelated information such as the historical repair state and the part loss degree of the air conditioner, and performs inspection and repair in accordance with a proposal distributed from the system via push notification, thereby improving the inspection and repair efficiency and quickly identifying the cause of the fault;
step 1207 of constructing a virtual space coordinate system with the origin representing a point indicating the device itself such that the maintenance operator can move and display a virtual air conditioner model in front of a person's eyes;
step 1208 of recognizing a hand by using a camera system, modeling a virtual hand model after recognizing the hand, capturing the posture of the hand in real time, and mapping the posture of the hand to the virtual hand model;
step 1209 of gripping a moving member by: performing real-time monitoring of collisions between the virtual hand model and the virtual air conditioner model; if a collision is completed, determining the movement direction of the hand; when the hand moves linearly, calculating a coordinate difference value between the hand model and the virtual air conditioner model; and adding the coordinate difference value to the coordinates of the hand model in real time, thereby realizing that the virtual device is always kept moving synchronously with the hand model and achieving the purpose of gripping and moving the model with the hand;
step 1210 of gripping a rotating member by: performing real-time monitoring of collisions between the virtual hand model and a virtual device model; if a collision is completed, determining the movement direction of the hand; in response to a rotational motion of the hand, acquiring the degree of arc of motion of the hand model; calculating a rotational angle about the device model; and providing the rotational angle to the virtual device in real time to achieve the purpose of rotating the model with the arm;
step 1211 of gripping and expanding a member with both hands by: performing real-time monitoring of collisions the virtual hand model and the virtual device model; if both hands completes the collision with the model, when both hands perform linear movement along the same axis, calculating the distance moved by both hands in the case of movements in opposite directions; dividing the calculated distance by the distance at the time of the collision; obtaining a coefficient C greater than 1; and multiplying all zoom values of the device model by the coefficient C to achieve an enlargement effect, whereas, conversely, achieve a size reduction effect;
step 1212 in which through the three steps described above, the three basic functions, namely, moving, rotating, and zooming, can be completed for the model by gestures, wherein after a part model is found, when a single tap action with a finger is recognized and a collision with the part model is completed, it is determined to perform the operation of selecting the part at this time, and information on the result is displayed with the part highlighted;
step 1213 of, after the part is selected, displaying inventory information, shipment information, historical repair records, and the like of the part, and directly generating an order detail page to directly place an order; and
step 1214 of, after the repair is completed, automatically recording the current repair status, and automatically recording the repair operator, the time, the spot, the content of the repair, and so on.

As can be seen from the above-described example, a simulation scene is created based on an engineering model of an installation location of a device and displayed, and a maintenance operator is assisted to identify a target device in the simulation scene. In addition, in a site where the target device is located, related information of the target device is displayed, and a maintenance operator is assisted to perform maintenance on the target device. In this way, a simulation scene of maintenance is formed based on the engineering model, the maintenance operator more easily identifies the target device, which requires maintenance, and the related information of the target device and the simple interaction with the simulation scene are displayed at the device site on the basis of the simulation scene. This helps the maintenance operator more quickly identify a target part that requires maintenance in the target device. Accordingly, not only the maintenance efficiency can be effectively improved, but also the simulation scene helps the maintenance operator inspect and repair a hidden device.

### <Example 2>

Example 2 of the present invention provides a device maintenance apparatus corresponding to the device maintenance method described in Example 1. The device maintenance apparatus can be specifically implemented with reference to an implementation of the method described in Example 1, and the redundant description of the same content or related portions will be omitted.

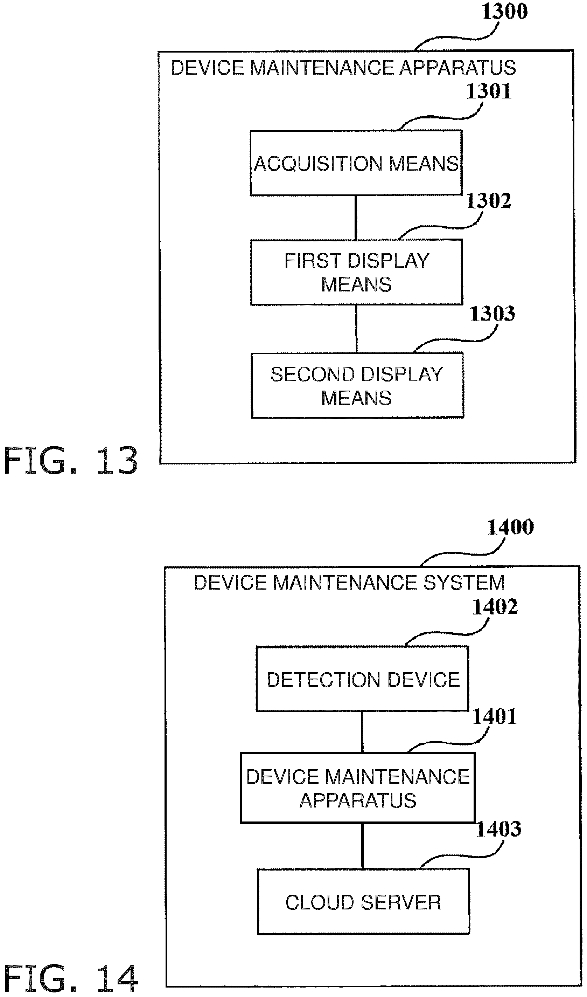

Fig. 13 is a schematic diagram of the device maintenance apparatus according to Example 2 of the present invention. As illustrated in Fig. 13, a device maintenance apparatus 1300 includes:
an acquisition means 1301 for acquiring an engineering model of an installation location of a device;
a first display means 1302 for creating and displaying a simulation scene based on the engineering model, and assisting a maintenance operator to identify a target device in the simulation scene; and
a second display means 1303 for, in a site where the target device is located, displaying related information of the target device, based on the simulation scene, and assisting the maintenance operator to perform maintenance on the target device.

In an example of the present invention, the device maintenance apparatus 1300 may be a terminal device.

For example, the apparatus is an augmented reality (AR) device, a virtual reality (VR) device, or a mixed reality (MR) device. Alternatively, some functions of the device maintenance apparatus 1300 may be implemented by a terminal device, and some functions may be implemented by a cloud server.

In an example of the present invention, the functions of each of the means described above may be implemented with reference to the content of the related step in Example 1, and the redundant description thereof will be omitted herein.

As can be seen from the above-described example, a simulation scene is created based on an engineering model of an installation location of a device and displayed, and a maintenance operator is assisted to identify a target device in the simulation scene. In addition, in a site where the target device is located, related information of the target device is displayed, and a maintenance operator is assisted to perform maintenance on the target device. In this way, a simulation scene of maintenance is formed based on the engineering model, the maintenance operator more easily identifies the target device, which requires maintenance, and the related information of the target device and the simple interaction with the simulation scene are displayed at the device site on the basis of the simulation scene. This helps the maintenance operator more quickly identify a target part that requires maintenance in the target device. Accordingly, not only the maintenance efficiency can be effectively improved, but also the simulation scene helps the maintenance operator inspect and repair a hidden device.

### <Example 3>

Example 3 of the present invention provides a device maintenance system including the device maintenance apparatus described in Example 2. The device maintenance system can be specifically implemented with reference to an implementation of the apparatus described in Example 2 and the method described in Example 1, and the redundant description of the same content or related portions will be omitted.

Fig. 14 is a structural diagram of the device maintenance system according to Example 3 of the present invention. As illustrated in Fig. 14, a device maintenance system 1400 includes:
a device maintenance apparatus 1401; and
a detection device 1402 that detects a line of sight and/or an action of a maintenance operator.

In an example of the present invention, the specific structure and functions of the device maintenance apparatus 1401 can be implemented with reference to the apparatus described in Example 2 and the method described in Example 1, and the redundant description thereof will be omitted herein.

In an example of the present invention, the detection device 1402 may be any detection device capable of detecting a line of sight and/or an action of the maintenance operator, such as a detection device including a camera device, for example.

As illustrated in Fig. 14, the device maintenance system 1400 may further include a cloud server 1403 that stores engineering models, device models, and maintenance data.

As can be seen from the above-described example, a simulation scene is created based on an engineering model of an installation location of a device and displayed, and a maintenance operator is assisted to identify a target device in the simulation scene. In addition, in a site where the target device is located, related information of the target device is displayed, and a maintenance operator is assisted to perform maintenance on the target device. In this way, a simulation scene of maintenance is formed based on the engineering model, the maintenance operator more easily identifies the target device, which requires maintenance, and the related information of the target device and the simple interaction with the simulation scene are displayed at the device site on the basis of the simulation scene. This helps the maintenance operator more quickly identify a target part that requires maintenance in the target device. Accordingly, not only the maintenance efficiency can be effectively improved, but also the simulation scene helps the maintenance operator inspect and repair a hidden device.

The apparatus and method according to the examples of the present invention described above may be implemented by hardware, or may be implemented by a combination of hardware and software. The present invention also relates to a computer-readable program that can cause, when executed by a logic component, the logic component to implement the apparatus or constituent components described above or the logic component to implement the various methods or steps described above.

Examples of the present invention further relate to a storage medium for storing the program described above, such as a hard disk, a magnetic disk, an optical disc, a DVD, or a flash memory.

It should be noted that the limitation of steps according to the present solution is not recognized as limiting the order of the steps, on the premise that such limitation does not affect a specific implementation of the solution, and that either of two successive steps may be executed first or later or both steps may be executed simultaneously. Any implementation of the present solution should be regarded as falling within the protection scope of the present application.

While the present application has been described with reference to specific embodiments, it should be understood by those skilled in the art that the description is illustrative and is not intended to limit the scope of the present application as claimed. A person skilled in the art may make various modifications and corrections to the present application based on the ideas and principles of the present application, and these modifications and corrections also fall within the scope of the present application.

## Claims

1. A device maintenance method comprising:
acquiring an engineering model of an installation location of a device;
creating and displaying a simulation scene based on the engineering model, and assisting a maintenance operator to identify a target device in the simulation scene; and
in a site where the target device is located, displaying related information of the target device, based on the simulation scene, and assisting the maintenance operator to perform maintenance on the target device.

2. The device maintenance method according to claim 1, wherein
creating and displaying a simulation scene based on the engineering model includes:
positioning the engineering model in the site where the target device is located, to superimpose the engineering model on the site, and displaying, with a terminal device, the engineering model.

3. The device maintenance method according to claim 2, wherein
positioning the engineering model in the site where the target device is located includes:
positioning the engineering model by two location points in the site;
positioning the engineering model by three location points in the site; or
positioning the engineering model by scanning a two-dimensional code in the site.

4. The device maintenance method according to claim 2, wherein
assisting a maintenance operator to identify a target device in the simulation scene includes:
detecting a voice, a line of sight, or blinking of the maintenance operator to identify a target device and a position of the target device in the simulation scene.

5. The device maintenance method according to claim 4, wherein
assisting a maintenance operator to identify a target device in the simulation scene further includes:
displaying, with the terminal device, a movement path for guiding the maintenance operator toward the target device.

6. The device maintenance method according to claim 1, wherein
displaying related information of the target device, based on the simulation scene, and assisting the maintenance operator to perform maintenance on the target device includes:
acquiring a device number and a part number of the target device;
searching for information on the target device and information on parts, based on a displayed device and part information table; and
acquiring information on a target part.

7. The device maintenance method according to claim 1, wherein
displaying related information of the target device, based on the simulation scene, and assisting the maintenance operator to perform maintenance on the target device includes:
acquiring a device model of the target device;
displaying parts of the device model in a developed form;
identifying a target part; and
acquiring information on the target part.

8. The device maintenance method according to claim 7, wherein
displaying parts of the device model in a developed form includes:
displaying, with a terminal device, the device model at a near end of a line of sight; and
displaying parts of the device model in a developed view in a form that simulates an assembly perspective view, in response to detection of a voice or gesture of the maintenance operator.

9. The device maintenance method according to claim 7, wherein
displaying parts of the device model in a developed form includes:
displaying the parts of the device model in a developed view in response to detection of a removal action of the target device by the maintenance operator.

10. The device maintenance method according to claim 7, wherein
identifying a target part includes:
searching names of the parts of the device model to acquire some selected parts in response to detection of a voice of the maintenance operator; and
highlighting the selected parts.

11. The device maintenance method according to claim 7, wherein
identifying a target part includes:
zooming, rotating, and translating a part of the parts displayed in a developed view, in response to detection of a gesture made by the maintenance operator; and
identifying a target part selected by the maintenance operator.

12. The device maintenance method according to claim 7, wherein
identifying a target part includes:
operating a part of the parts displayed in a developed view, in response to detection of a line of sight of the maintenance operator; and
identifying a target part selected by the maintenance operator, in response to detection of blinking of the maintenance operator.

13. The device maintenance method according to claim 7, wherein
identifying a target part includes:
acquiring at least one of historical maintenance information, operation information, or fault information of the target device;
identifying a candidate target part, based on at least one of the historical maintenance information, the operation information, or the fault information of the target device; and
distributing the candidate target part to the maintenance operator via push notification.

14. The device maintenance method according to claim 13, wherein
the fault information includes a fault code, and
identifying a candidate target part, based on at least one of the historical maintenance information, the operation information, or the fault information of the target device includes:
determining, as the candidate target part, a part in which a fault corresponding to the fault code may occur.

15. The device maintenance method according to claim 13, wherein
identifying a candidate target part, based on at least one of the historical maintenance information, the operation information, or the fault information of the target device includes:
inputting at least one of a use operation state, operation data, or a loss operation state of each of parts of the target device into a prediction model; and
determining, as the candidate target part, a target part output from the prediction model.

16. The device maintenance method according to claim 13, wherein
identifying a candidate target part, based on at least one of the historical maintenance information, the operation information, or the fault information of the target device includes:
identifying the candidate target part, based on a number of repairs of each of the parts in the historical maintenance information of the target device.

17. The device maintenance method according to claim 13, wherein
distributing the candidate target part to the maintenance operator via push notification includes:
highlighting the candidate target part.

18. The device maintenance method according to claim 7, wherein
acquiring information on the target part includes:
searching for and displaying detailed information of the target part in response to selection of the target part by the maintenance operator.

19. The device maintenance method according to claim 18, wherein
the detailed information of the target part includes at least one of shipment information, supplier information, price information, inventory information, repair guidance information, or attachment-and-removal guidance information of the target part.

20. The device maintenance method according to claim 19, wherein
the detailed information further includes order information of the target part.

21. The device maintenance method according to claim 20, further comprising:
generating an order based on the order information in response to an operation of the maintenance operator.

22. A device maintenance method comprising:
acquiring an engineering model of an installation location of a device;
positioning the engineering model in a site where a target device is located, to superimpose the engineering model on the site, and displaying, with a terminal device, the engineering model;
assisting a maintenance operator to identify the target device, based on the displayed engineering model;
identifying a target part based on an actual detection result of the target part and/or parts, the actual detection result being distributed via push notification;
displaying a device model of the target device, and displaying parts of the device model in a developed view;
operating the target part in the parts displayed in a developed view, in response to an action of the maintenance operator;
acquiring information on the target part; and
generating order information of the target part.

23. A device maintenance apparatus comprising:
acquisition means for acquiring an engineering model of an installation location of a device;
first display means for creating and displaying a simulation scene based on the engineering model, and assisting a maintenance operator to identify a target device in the simulation scene; and
second display means for, in a site where the target device is located, displaying related information of the target device, based on the simulation scene, and assisting the maintenance operator to perform maintenance on the target device.

24. The device maintenance apparatus according to claim 23, wherein
the device maintenance apparatus is an augmented reality (AR) device, a virtual reality (VR) device, or a mixed reality (MR) device.
